# FASCICULE DE BREVET EUROPEEN

(11) **EP 3 798 845 B1**
(45) Date de publication et mention de la délivrance du brevet: **22.02.2023**
(21) Numéro de dépôt: 20198142.0
(22) Date de dépôt: 24.09.2020
(51) Int. Cl.: G06F 11/18, G01R 31/3185, G06F 11/16, G06F 11/267, G01R 31/3181

(54) **PROCÉDÉ DE DÉTECTION D'ERREURS**
FEHLERERKENNUNGSVERFAHREN
ERROR DETECTION METHOD

(30) Priorité: 27.09.2019 FR 1910708
(43) Date de publication de la demande: 31.03.2021
(73) Titulaire: STMICROELECTRONICS SA, 92120 Montrouge (FR)
(72) Inventeur: GOMEZ GOMEZ, Ricardo, 38000 GRENOBLE (FR)
(74) Mandataire: Cabinet Beaumont

(56) Documents cités:
- US-A1- 2001 038 304
- US-A1- 2005 154 947
- US-A1- 2007 028 157
- US-A1- 2008 086 666
- US-A1- 2010 088 565

## Description

### Domaine technique

La présente description concerne de façon générale la détection d'erreurs dans un dispositif électronique, et plus particulièrement la détection d'erreurs par comparaison de dispositifs électroniques. La présente description concerne, de plus, un dispositif permettant de mettre en oeuvre un tel procédé de détection d'erreurs dans un dispositif électronique.

### Technique antérieure

L'utilisation, dans un système électronique, de dispositifs électroniques, comme des processeurs, des microprocesseurs, des systèmes intégrés, etc., est de plus en plus soumise à des contraintes de performances et de fiabilité. Pour satisfaire à certaines normes et/ou charte de qualité, ces dispositifs sont généralement couplés à des dispositifs de détection et/ou de correction d'erreurs. En effet, des erreurs de fonctionnement peuvent se présenter lors de l'exécution d'un de ces dispositifs et perturber leurs fonctionnements et/ou le fonctionnement global d'un système électronique les comprenant.

Plusieurs types d'erreurs, ou fautes, peuvent se produire au sein d'un dispositif électronique. A titre d'exemple, certaines erreurs (SPF, Single Point Fault) produisent directement, ou rapidement, un effet sur le fonctionnement du dispositif électronique et/ou sur le fonctionnement global d'un système électronique le comprenant. Ces erreurs sont facilement reconnaissables par observation du dispositif et/ou du système. D'autres erreurs (LFM, Latent Fault Metric), dites erreurs latentes, ne produisent pas instantanément de dysfonctionnement, mais peuvent en produire, par exemple ultérieurement, ou lorsqu'elles sont combinées à d'autres erreurs. Ce sont des erreurs plus difficiles à détecter car une simple observation du fonctionnement du dispositif ou du système n'est généralement pas suffisante.

Il existe donc un besoin pour des procédés de détection d'erreurs dans les dispositifs électroniques, et des dispositifs adaptés à mettre en oeuvre ces procédés, plus performants.

Le document US2007/0028157 divulgue un procédé de détection d'erreurs comprenant la comparaison d'au moins deux dispositifs électroniques identiques comprenant des données de test, comprenant les étapes suivantes:(a) les données de test en dernière position des deux dispositifs sont comparées; les données de test de l'étape (a) sont écrites en première position, les étapes (a) et (c) sont répétées jusqu'à ce que toutes les données de test reprennent leur place initiale. Les documents US2005154947 et US2008086666 A1 décrivent un ensemble de bascules dont les sorties sont comparées et rebouclées dans un contexte de type test scan. Résumé de l'invention

Il existe un besoin pour un procédé de détection d'erreurs dans un dispositif électronique.

Il existe un besoin pour dispositif de détection d'erreurs dans un dispositif électronique.

Il existe un besoin pour un dispositif et un procédé de détection d'erreurs indépendant de la nature du dispositif à surveiller.

Il existe un besoin pour un dispositif et un procédé de détection d'erreurs dans un dispositif électronique simple à mettre en oeuvre.

Un mode de réalisation pallie tout ou partie des inconvénients des procédés de détection d'erreurs, et des dispositifs mettant en oeuvre un tel procédé, connus.

L'invention prévoit un procédé de détection d'erreurs comprenant la comparaison d'au moins deux dispositifs électroniques identiques comprenant au moins une chaîne de données de test, chaque donnée de test étant stockée dans un point de test, les points de test étant disposés dans le dispositif dès sa conception et la donnée de test stockée étant une donnée donnant une indication sur l'état du ou des composants auxquels le point de test est rattaché, ledit procédé comprenant les étapes suivantes :
(a) les données de test en dernière position dans ladite chaîne des deux dispositifs sont comparées ;
(b) les autres données de test sont avancées d'une position dans leur chaîne de données ;
(c) les données de test de l'étape sont écrites en première position dans leur chaîne initiale,
les étapes, et sont répétées jusqu'à ce que toutes les données de test reprennent leur place initiale.

Selon un mode de réalisation, les points de test sont des registres ou des bascules.

Selon un mode de réalisation, les données de test sont des mots binaires.

Selon un mode de réalisation, les données de test sont des mots binaires de un bit.

Selon un mode de réalisation, les dispositifs électroniques comprennent deux ou plus de deux chaînes de données de test.

Selon un mode de réalisation, le procédé est un procédé de comparaison de plus de deux dispositifs électroniques identiques.

Selon un mode de réalisation, le résultat de la comparaison de l'étape est fourni dans un signal.

Un autre mode de réalisation prévoit un dispositif de comparaison adapté à mettre en oeuvre le procédé décrit ci-dessus.

Selon un mode de réalisation, le dispositif est adapté à comparer au moins deux dispositifs électroniques identiques comprenant au moins une chaîne de données de test, comprenant :
- un circuit comparateur ; et
- au moins deux boucles de rétroaction reliant chacune une entrée et une sortie d'une desdites chaînes.

Selon un mode de réalisation, chaque boucle de rétroaction relie l'entrée et la sortie d'une desdites chaînes par l'intermédiaire d'un multiplexeur.

Selon un mode de réalisation, le circuit comparateur comprend une porte logique OU exclusif.

Un autre mode de réalisation prévoit un système électronique comprenant :
- au moins deux dispositifs électroniques identiques comprenant au moins une chaîne de données de test ; et
- un dispositif de comparaison décrit précédemment.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon schématique et sous forme de blocs, un dispositif électronique ;
la figure 2 représente, de façon schématique et sous forme de blocs, un mode de réalisation d'un dispositif de détection d'erreurs dans un dispositif électronique du type du dispositif de la figure 1 ;
la figure 3 illustre la mise en oeuvre du dispositif de la figure 2 ;
la figure 4 illustre la mise en oeuvre du dispositif de la figure 2 ;
la figure 5 représente, de façon schématique et sous forme de blocs, un autre mode de réalisation d'un dispositif de détection d'erreurs dans un dispositif électronique du type du dispositif de la figure 1 ;
la figure 6 représente un circuit logique d'un comparateur d'un mode de réalisation d'un dispositif de détection d'erreurs ;
la figure 7 représente un circuit logique d'un comparateur d'un mode de réalisation d'un dispositif de détection d'erreurs.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

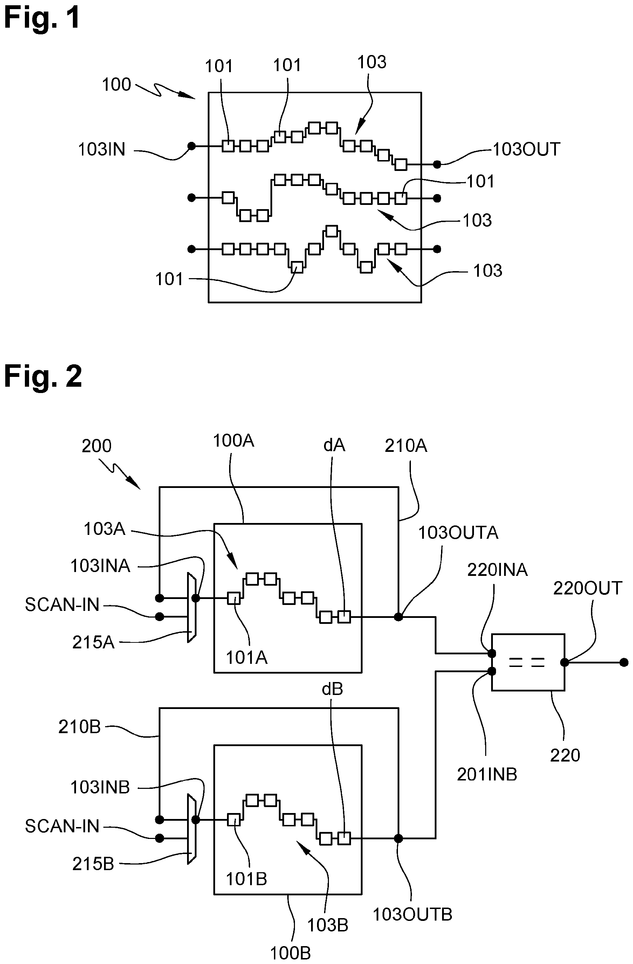

La figure 1 représente, de façon schématique et sous forme de blocs, un dispositif électronique 100. Le dispositif électronique 100 est par exemple un processeur, un microprocesseur, un système intégré, une unité de commande etc.

Le dispositif électronique 100 comprend plusieurs points de test 101. Chaque point de test 101 stocke une donnée fonctionnelle, utilisée pendant le fonctionnement du dispositif 100, et appelée donnée de test pendant une phase de test. A titre d'exemple, un point de test 101 est un registre, ou une bascule. La donnée de test est, par exemple, un mot binaire codé sur N bits. A titre d'exemple, N est compris entre 1 et 64 bits, par exemple, égal à un. Les points de test 101 sont, par exemple, disposés dans le dispositif 100 dès sa conception, et sont chacun rattachés à un ou plusieurs modules ou composants du dispositif 100. La donnée de test stockée dans un point de test 101 est une donnée donnant une indication sur l'état du ou des composants auxquels le point de test est rattaché. Les points de test 101 sont organisés en une ou plusieurs chaînes de test 103. Chaque chaîne de test 103 comprend un point d'entrée 103IN et un point de sortie 103OUT.

Le dispositif 100 peut comprendre autant de points de test 101 que nécessaire, organisés en autant de chaînes de test 103 que nécessaires. Les chaînes de test 103 ont, de préférence, toutes le même nombre de points de test 101, mais peuvent, à titre de variante, avoir des nombres de points 101 de test différents. A titre d'exemple, le dispositif 100 illustré en figure 1 comprend, par exemple, trente-trois points de test 101 organisés en trois chaînes de test 103 comprenant chacune onze points de test 101.

Une phase de détection d'erreurs, ou de test, du dispositif 100 consiste généralement en la lecture et de comparaison de toutes les données stockées dans les points de test. Le nombre de points de test 101 compris dans le dispositif 100 influe donc sur la durée d'une phase de test. En effet, plus le dispositif 100 comprend de points de test 101, plus la phase de test risque d'être longue. L'organisation des points de test 101 en chaînes de test 103 peut permettre de raccourcir cette durée en permettant la lecture de plusieurs points de test 101 en parallèle.

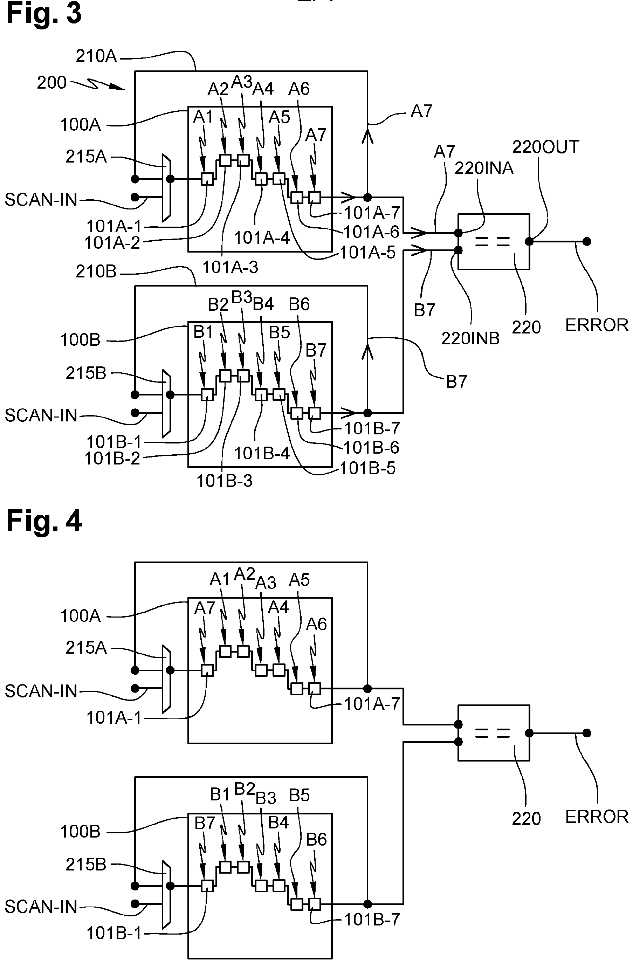

Un dispositif et procédé de détection d'erreurs dans le dispositif 100 seront décrits en relation avec les figures 2 et 3.

La figure 2 représente, de façon schématique et sous forme de blocs, un mode de réalisation d'un dispositif de détection d'erreurs 200 par comparaison de deux dispositifs 100A et 100B identiques du type du dispositif 100 de la figure 1. Plus particulièrement, les dispositifs 100A et 100B sont identiques dans leur structure, mais ont également traité les mêmes opérations de fonctionnement et devrait avoir des données de test identiques.

Selon un exemple de réalisation, chaque dispositif 100A, respectivement 100B comprend une chaîne de test 103A, respectivement 103B, comprenant des points de test 101A, respectivement 101B. A titre d'exemple, chaque chaîne de test 103A, respectivement 103B, comprend sept points de test 101A, respectivement 101B. Chaque chaîne de test 103A, respectivement 103B, comprend une entrée 103INA, respectivement 103INB, et une sortie 103OUTA, respectivement 103INB. Le dernier point de test 101A, respectivement 101B, de chaque chaîne de test 103A, respectivement 103B, stocke une donnée dA, respectivement dB.

Le circuit de détection 200 comprend deux boucles de rétroaction 210A et 210B. La boucle de réaction 210A relie, de préférence connecte, la sortie 103OUTA, de la chaîne de test 103A du dispositif 100A, à une entrée d'un multiplexeur 215A. La boucle de rétroaction 210B relie, de préférence connecte, la sortie 103OUTB, de la chaîne de test 103B du dispositif 100B, à une entrée d'un multiplexeur 215B. Chaque multiplexeur 215A, respectivement 215B, comprend une deuxième entrée recevant un signal SCAN-IN. Chaque multiplexeur 215A, respectivement 215B, comprend, en outre, une sortie reliée, de préférence connectée, à l'entrée de la chaîne de test 103A, respectivement 103B. Les multiplexeurs 215A, 215B sont des points d'entrées pour ajouter des données aux chaînes de test 103A et 103B, et laissent la possibilité d'ajouter des données venant des boucles de rétroaction 210A et 210B ou venant d'autres points ou d'autres dispositifs.

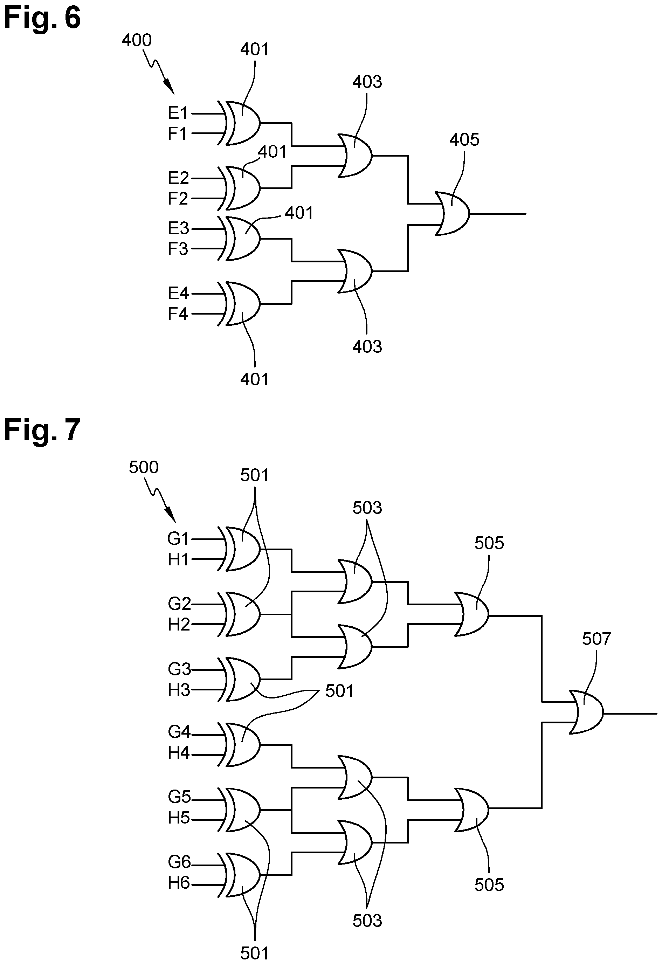

Le circuit de détection 200 comprend, en outre, un circuit comparateur 220 comprenant deux entrées 220INA et 220INB, et une sortie 220OUT. L'entrée 220INA est reliée, de préférence connectée, à la sortie 103OUTA de la chaîne de test 103A du dispositif 100A. L'entrée 220INB est reliée, de préférence connectée, à la sortie 103OUTB de la chaîne de test 103B du dispositif 100B. La sortie 220OUT fournit un signal exprimant le résultat de la comparaison entre les deux signaux fournis en entrée. Le circuit comparateur 220 est, par exemple, une porte logique de type OU exclusif. D'autres exemples de circuits comparateurs s'adaptant à différents types de dispositifs seront décrits en relation avec les figures 6 et 7.

Un procédé de détection d'une erreur utilisant le dispositif de détection 200 va maintenant être décrit en relation avec les figures 3 et 4.

Les figures 3 et 4 illustrent, de façon schématique et sous forme de blocs, la mise en oeuvre du dispositif de détection 200 décrit en relation avec la figure 2.

Les points de test des chaînes de test 103A et 103B sont numérotés de 101A-1 à 101A-M, et 101B-1 à 101B-M, et stockent des données A1 à AM, et B1 à BM. En particulier en figures 3 et 4, le nombre de points de test par chaîne de test est sept, donc les points de test des chaînes de test 103A et 103B sont numérotés de 101A-1 à 101A-7, et 101B-1 à 101B-7, et stockent des données A1 à A7, et B1 à B7.

Au début d'une phase de détection d'erreurs (figure 3), les données AM et BM (A7 et B7 en figure 3), stockées dans les derniers points de test 101AM et 101BM des chaînes de test 103A et 103B, sont envoyées sur les entrées 220INA et 220INB du comparateur 220 pour y être comparées. Les dispositifs 100A et 100B étant identiques, de par leur structure et de par leur état, les données AM et BM sont censées être identiques également. Si ce n'est pas le cas, alors une erreur est détectée, et le comparateur fournit un signal d'erreur ERROR sur sa sortie 220OUT.

Chaque donnée AM, respectivement BM est, en outre, envoyée, par la boucle de rétroaction 210A, respectivement 210B, vers une entrée du multiplexeur 215A, respectivement 215B.

Une fois les données AM et BM comparées (figure 4), les données Ai, i variant de 1 à M-1, sont décalées vers le point de test suivant 101A-i+1, et les données Bi sont décalées vers le point de test suivant 101B-i+1. De plus, la donnée AM, respectivement BM, est écrite, sans être modifiée, dans le point de test 101A-1, respectivement 101B-1, par le multiplexeur 215A, respectivement 215B.

La phase de détection d'erreurs continue par la comparaison des données AM-1 et BM-1 stockées dans les points de test 101A-M et 101B-M et par le décalage des autres données dans les points de test immédiatement suivants. La phase de test se termine une fois que toutes les données Ai ont été comparées aux données Bi, et, qu'à force de décalages, les données AM et BM ont retrouvé leur position initiale.

Un avantage du dispositif de détection 200, et du procédé de détection résultant de sa mise en oeuvre, est qu'il permet de détecter différents types d'erreurs. Plus particulièrement, il permet de détecter les erreurs sans observer le fonctionnement des dispositifs 100A, 100B ou le fonctionnement global du système dont ils font partie. Le dispositif de détection 200 permet donc également de détecter aussi bien les erreurs (SPF, Single Point Fault) ayant une influence directe sur le fonctionnement, que les erreurs (LFM, Latent Fault Metric) qui n'ont pas d'influence immédiate sur le fonctionnement des dispositifs 100A et 100B.

Un autre avantage du dispositif de détection 200 est qu'il est indépendant de la nature des dispositifs 100A et 100B et peut s'appliquer à n'importe quel type de dispositif comprenant des chaînes de test du type de celles décrites en relation avec la figure 1.

Un autre avantage du dispositif de détection 200 est qu'il est facile à mettre en oeuvre dans un système comprenant des dispositifs électroniques du type du dispositif 100 décrit en relation avec la figure 1, puisqu'il ne comprend qu'un circuit de comparaison, des boucles de rétroaction et des multiplexeurs.

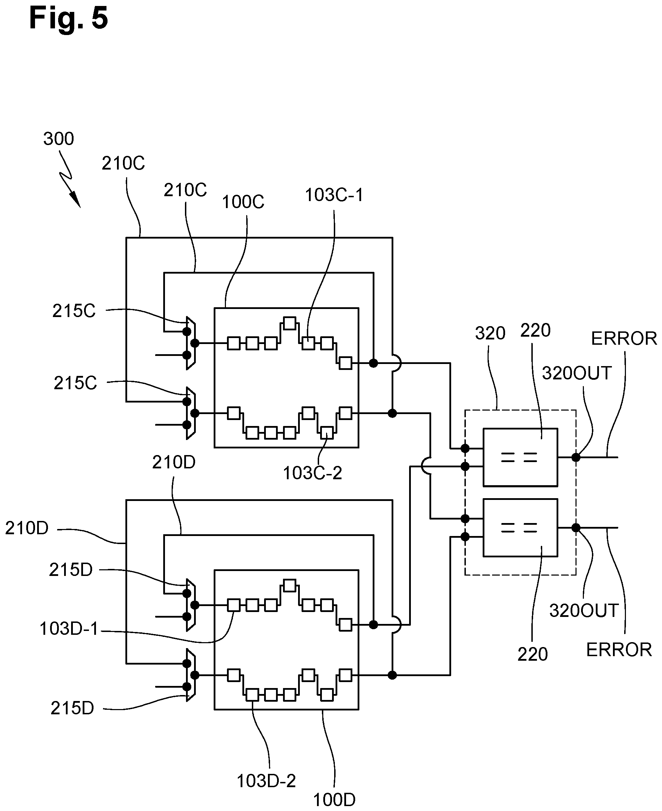

La figure 5 représente, de façon schématique et sous forme de blocs, un mode de réalisation d'un dispositif de détection d'erreurs 300 entre deux dispositifs 100C et 100D identiques du type du dispositif 100 de la figure 1. Plus particulièrement, les dispositifs 100C et 100D sont identiques dans leur structure, mais ont également traité les mêmes opérations de fonctionnement et devrait avoir des données de test identiques.

Les dispositifs 100C et 100D sont identiques aux dispositifs 100A et 100B, mais ne comprennent chacun non pas une seule chaîne de test mais plusieurs. A titre d'exemple, en figure 5, les dispositifs 100C et 100D comprennent chacun deux chaînes de test 103C-1 et 103C-2, 103D-1 et 103D-2, les chaînes 103C-1 et 103C-2, respectivement 103D-1 et 103D-2, étant différentes les unes des autres.

Le dispositif de détection d'erreurs 300 est similaire au dispositif de détection d'erreurs 200 à la différence qu'il comprend autant de boucles de rétroaction 210C, respectivement 210D, et de multiplexeurs 215C, respectivement 215D, que de chaînes de test 103C, respectivement 103D. Plus particulièrement, chaque chaîne de test 103C, respectivement 103D, a son entrée reliée, de préférence connectée, à une entrée d'un multiplexeur 215C, respectivement 215D, par une boucle de rétroaction 210C, respectivement 210D, la sortie du multiplexeur 215C, respectivement 215D, étant reliée, de préférence connectée à l'entrée de ladite chaîne de test 103C, respectivement 103D. En figure 5, le dispositif 300 comprend donc quatre boucles de rétroaction 210C et 210D, et quatre multiplexeurs 215C et 215D.

Le dispositif 300 comprend, en outre, un circuit comparateur 320 ayant autant d'entrées que le nombre total de chaînes de test 103C et 103D. En figure 5, le circuit 320 comprend quatre entrées. Le dispositif 300 reçoit, en entrée, toutes les sorties des chaînes de test 103C et 103D. Plus particulièrement, le circuit comparateur 320 permet de comparer les chaînes 103C et 103D censées être identiques. Le circuit 320 peut comprendre une ou plusieurs sorties 320OUT. En figure 5, le circuit 320 a deux sorties. Dans le cas où le circuit 320 ne comprend qu'une seule sortie, cette sortie peut fournir un signal représentant une information de comparaison globale entre les deux dispositifs. Dans le cas où le circuit 320 comprend plusieurs sorties 320OUT, chaque sortie peut par exemple fournir un signal représentant la comparaison entre deux chaînes de test.

A titre d'exemple, le circuit comparateur comprend autant de circuits comparateurs 220 décrit en relation avec la figure 2 que de chaînes de test dans un dispositif 100C, 100D. En figure 5, le circuit comparateur 320 comprend deux circuits 220. D'autres modes de réalisation du circuit comparateur 320 seront décrits en relation avec les figures 6 et 7.

Le fonctionnement du dispositif 300 est le même que le fonctionnement du dispositif 200 décrit en relation avec la figure 2, les comparaisons des différents jeux de chaînes de test 103C, 103D, sont effectuées en parallèle.

La figure 6 représente un circuit logique 400 d'un circuit de comparaison d'un dispositif de détection du type de celui décrit en relation avec les figures 2 et 3.

Le circuit logique 400 est un circuit logique permettant de comparer les données de deux dispositifs E et F identiques, comprenant chacun quatre chaînes de test E1 à E4, respectivement F1 à F4. Les données de la chaîne de test Ei, i variant de 1 à 4, sont comparées aux données de la chaîne de test Fi.

Le circuit logique 400 comprend un premier étage comprenant quatre portes logiques 401 de type ou exclusif (XOR). Chacune de ces portes reçoit en entrée une donnée d'une chaîne de test Ei et d'une chaîne de test Fi pour les comparer.

Le circuit logique 400 comprend un deuxième étage comprenant deux portes logiques 403 de type ou (OR). Chacune de ces portes 403 reçoit en entrée une sortie d'une des portes logiques 401 du premier étage.

Le circuit logique 400 comprend un troisième étage comprenant une porte logique 405 de type ou (OR). La porte logique reçoit en entrée les sorties des portes logiques 403 du deuxième étage.

La figure 7 représente un circuit logique 500 d'un circuit de comparaison d'un dispositif de détection du type de celui décrit en relation avec les figures 2 et 3.

Le circuit logique 500 est un circuit logique permettant de comparer les données de deux dispositifs G et H identiques, comprenant chacun six chaînes de test G1 à G6, respectivement H1 à H6. Les données de la chaîne de test Gi, i variant de 1 à 6, sont comparée aux données de la chaîne de test Hi.

Le circuit logique 500 comprend un premier étage comprenant six portes logiques 501 de type ou exclusif (XOR). Chacune de ces portes reçoit en entrée une donnée d'une chaîne de test Gi et d'une chaîne de test Hi pour les comparer.

Le circuit logique 500 comprend un deuxième étage comprenant quatre portes logiques 503 de type ou (OR). Chacune de ces portes reçoit en entrée une sortie d'une des portes logiques 501 du premier étage. Plus particulièrement, certaines portes 501 fournissent leur sortie à plusieurs portes 503 (voir figure 7).

Le circuit logique 500 comprend un troisième étage comprenant deux portes logiques 505 de type ou (OR). Chaque porte logique 505 reçoit en entrée les sorties des portes logiques 503 du deuxième étage.

Le circuit logique 500 comprend un quatrième étage comprenant une porte logique 507 de type ou (OR). La porte logique reçoit en entrée les sorties des portes logiques 505 du troisième étage.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les dispositifs de détection d'erreurs 200 et 300 pourraient être adaptés pour comparer plus de deux dispositifs de type du dispositif 100 décrit en relation avec la figure 1.

Enfin, la mise en oeuvre pratique des modes de réalisation et variantes décrits est à la portée de l'homme du métier à partir des indications fonctionnelles données ci-dessus.

## Revendications

1. Procédé de détection d'erreurs comprenant la comparaison d'au moins deux dispositifs électroniques (100A, 100B ; 100C, 100D) identiques comprenant au moins une chaîne (103A, 103B ; 103C-1, 103C-2, 103D-1, 103C-2) de données de test (A1 à AM, B1 à BM), chaque donnée de test (A1 à AM, B1 à BM) étant stockée dans un point de test (101A, 101B ; 101C, 101D), les points de test étant disposés dans le dispositif dès sa conception et la donnée de test stockée étant une donnée donnant une indication sur l'état du ou des composants auxquels le point de test est rattaché, ledit procédé comprenant les étapes suivantes :
(a) les données de test en dernière position dans ladite chaîne (103A, 103B ; 103C-1, 103C-2, 103D-1, 103C-2) des deux dispositifs (100A, 100B ; 100C, 100D) sont comparées ;
(b) les autres données de test sont avancées d'une position dans leur chaîne de données ;
(c) les données de test de l'étape (a) sont écrites en première position dans leur chaîne initiale (103A, 103B ; 103C-1, 103C-2, 103D-1, 103C-2),
les étapes (a), (b), et (c) sont répétées jusqu'à ce que toutes les données de test (A1 à AM, B1 à BM) reprennent leur place initiale.

2. Procédé selon la revendication 1, dans lequel les points de test (101A, 101B ; 101C, 101D) sont des registres ou des bascules.

3. Procédé selon la revendication 1, dans lequel les données de test (A1 à AM, B1 à BM) sont des mots binaires.

4. Procédé selon l'une quelconque des revendications 1 à 3, dans lequel les données de test (A1 à AM, B1 à BM) sont des mots binaires de un bit.

5. Procédé selon l'une quelconque des revendications 1 à 4, dans lequel les dispositifs électroniques comprennent deux ou plus de deux chaînes (103A, 103B ; 103C-1, 103C-2, 103D-1, 103C-2) de données de test.

6. Procédé selon l'une quelconque des revendications 1 à 5, de comparaison de plus de deux dispositifs électroniques identiques.

7. Procédé selon l'une quelconque des revendications 1 à 6, dans lequel le résultat de la comparaison de l'étape (a) est fourni dans un signal (ERROR).

8. Dispositif de comparaison adapté à mettre en oeuvre le procédé selon l'une quelconque des revendications 1 à 7.

9. Dispositif selon la revendication 8, adapté à comparer au moins deux dispositifs électroniques (100A, 100B ; 100C, 100D) identiques comprenant au moins une chaîne de données de test (103A, 103B ; 103C-1, 103C-2, 103D-1, 103C-2), comprenant :
- un circuit comparateur (220 ; 320) ; et
- au moins deux boucles de rétroaction (210A, 210B ; 210C, 210D) reliant chacune une entrée et une sortie d'une desdites chaînes (103A, 103B ; 103C-1, 103C-2, 103D-1, 103C-2).

10. Dispositif selon la revendication 8 ou 9, dans lequel chaque boucle de rétroaction (210A, 210B ; 210C, 210D) relie l'entrée et la sortie d'une desdites chaînes (103A, 103B ; 103C-1, 103C-2, 103D-1, 103C-2) par l'intermédiaire d'un multiplexeur (215A, 215B ; 215C, 215D).

11. Dispositif selon l'une quelconque des revendications 8 à 10, dans lequel le circuit comparateur (220 ; 320 ; 400 ; 500) comprend une porte logique OU exclusif.

12. Système électronique comprenant :
- au moins deux dispositifs électroniques (100A, 100B ; 100C, 100D) identiques comprenant au moins une chaîne (103A, 103B ; 103C-1, 103C-2, 103D-1, 103C-2) de données de test (A1 à AM, B1 à BM) ; et
- un dispositif de comparaison selon l'une quelconque des revendications 8 à 11.

## Patentansprüche

1. Verfahren zur Fehlererkennung, aufweisend den Vergleich von mindestens zwei identischen elektronischen Vorrichtungen (100A, 100B; 100C, 100D), die mindestens eine Kette (103A, 103B; 103C, 103D) von Testdaten (A1 bis AM, B1 bis BM) aufweisen, wobei alle Testdaten (A1 bis AM, B1 bis BM) an einem Testpunkt (101A, 101B; 101C, 101D) gespeichert sind, wobei die Testpunkte in der Vorrichtung seit dem Zeitpunkt der Entwicklung angeordnet sind und die gespeicherten Testdaten Daten sind, die einen Hinweis über den Zustand der einen oder der mehreren Komponenten geben, an denen der Testpunkt angebracht ist, wobei das Verfahren die folgenden Schritte aufweist
(a) die Testdaten der letzten Position in der Kette der beiden Vorrichtungen (100A, 100B; 100C, 100D) werden verglichen;
(b) die anderen Testdaten (103A, 103B; 103C, 103D) werden in ihrer Datenkette um eine Position nach vorne verschoben;
(c) die Testdaten von Schritt (a) werden an die erste Position in ihrer ursprünglichen Kette (103A, 103B; 103C, 103D) geschrieben,
die Schritte (a), (b) und (c) werden wiederholt, bis alle Testdaten (A1 bis AM, B1 bis BM) ihre ursprüngliche Position wieder eingenommen haben.

2. Verfahren oder Vorrichtung nach Anspruch 1, wobei die Testpunkte (101A, 101B; 101C, 101D) Register oder Flipflops sind.

3. Verfahren nach Anspruch 1, wobei die Testdaten (A1 bis AM, B1 bis BM) Binärwörter sind.

4. Verfahren nach einem der Ansprüche 1 bis 3, wobei die Testdaten (A1 bis AM, B1 bis BM) Ein-Bit-Binärwörter sind.

5. Verfahren nach einem der Ansprüche 1 bis 4, wobei die elektronischen Vorrichtungen zwei oder mehr als zwei Ketten (103A, 103B; 103C, 103D) von Testdaten aufweisen.

6. Verfahren nach einem der Ansprüche 1 bis 5 zum Vergleich von mehr als zwei identischen elektronischen Vorrichtungen.

7. Verfahren nach einem der Ansprüche 1 bis 6, wobei das Ergebnis des Vergleichs von Schritt (a) in einem Signal (ERROR) ausgegeben wird.

8. Vorrichtung zum Vergleichen, das zur Durchführung des Verfahrens nach einem der Ansprüche 1 bis 7 geeignet ist.

9. Vorrichtung nach Anspruch 8, die geeignet ist, mindestens zwei identische elektronische Vorrichtungen (100A, 100B; 100C, 100D) zu vergleichen, die mindestens eine Kette von Testdaten (103A, 103B; 103C, 103D) aufweisen, wobei die Vorrichtung Folgendes aufweist:
- eine Komparatorschaltung (220; 320); und
- mindestens zwei Rückkopplungsschleifen (210A, 210B; 210C, 210D), die jeweils einen Eingang und einen Ausgang einer der Ketten (103A, 103B; 103C, 103D) koppeln.

10. Vorrichtung nach Anspruch 8 oder 9, wobei jede Rückkopplungsschleife (210A, 210B; 210C, 210D) den Eingang und den Ausgang einer der Ketten (103A, 103B; 103C, 103D) über einen Multiplexer (215A, 215B; 215C, 215D) koppelt.

11. Vorrichtung nach einem der Ansprüche 8 bis 10, wobei die Komparatorschaltung (220; 320; 400; 500) ein logisches XOR-Gatter aufweist.

12. Ein elektronisches System, das Folgendes aufweist:
- mindestens zwei identische elektronische Vorrichtungen (100A, 100B; 100C, 100D) die mindestens einer Kette (103A, 103B; 103C, 103D) von Testdaten (A1 bis AM, B1 bis BM) aufweisen; und
- die Vergleichsvorrichtung nach einem der Ansprüche 8 bis 11.

## Claims

1. An error detection method comprising comparing at least two identical electronic devices (100A, 100B; 100C, 100D) comprising at least one chain (103A, 103B; 103C, 103D) of test data (A1 to AM, B1 to BM), each test data (Z1 to AM, B1 to m) being stored dans un test point (101A, 101B; 101C, 1011D), test points being arranged in the device from the moment of conception and the stored test data being a data giving an indication about the state of the one or the several components to which the test point is attached, the method comprising the steps of:
(a) the test data in the last position in said chain of the two devices (100A, 100B; 100C, 100D) are compared;
(b) the other test data (103A, 103B; 103C, 103D) are shifted forward by one position in their data chain;
(c) the test data of step (a) are written in the first position in their initial chain (103A, 103B; 103C, 103D),
steps (a), (b), and (c) are repeated until all the test data (A1 to AM, B1 to BM) have recovered their initial location.

2. The method or device of claim 1, wherein the test points (101A, 101B; 101C, 101D) are registers or flip-flops.

3. The method of claim 1, wherein the test data (A1 to AM, B1 to BM) are binary words.

4. The method of any of claims 1 to 3, wherein the test data (A1 to AM, B1 to BM) are one-bit binary words.

5. The method of any of claims 1 to 4, wherein the electronic devices comprise two or more than two chains (103A, 103B; 103C, 103D) of test data.

6. The method of any of claims 1 to 5, for comparing more than two identical electronic devices.

7. The method of any of claims 1 to 6, wherein the result of the comparison of step (a) is delivered in a signal (ERROR).

8. A device for comparing adapted to execute the method of any of claims 1 to 7.

9. The device of claim 8, adapted to compare at least two identical electronic devices (100A, 100B; 100C, 100D) comprising at least one chain of test data (103A, 103B; 103C, 103D), comprising:
- a comparator circuit (220; 320); and
- at least two feedback loops (210A, 210B; 210C, 210D), each coupling an input and an output of one of said chains (103A, 103B; 103C, 103D).

10. The device of claim 8 or 9, wherein each feedback loop (210A, 210B; 210C, 210D) couples the input and the output of one of said chains (103A, 103B; 103C, 103D) via a multiplexer (215A, 215B; 215C, 215D).

11. The device of any of claims 8 to 10, wherein the comparator circuit (220; 320; 400; 500) comprises an XOR logic gate.

12. An electronic system comprising:
- at least two identical electronic devices (100A, 100B; 100C, 100D) comprising at least one chain (103A, 103B; 103C, 103D) of test data (A1 to AM, B1 to BM); and
- the comparison device of any of claims 8 to 11.
